# EUROPEAN PATENT APPLICATION

(11) **EP 4 648 559 A1**
(43) Date of publication of application: **12.11.2025**
(21) Application number: 24382510.6
(22) Date of filing: 10.05.2024
(51) Int. Cl.: H05K 7/20

(54) **COOLED POWER ELECTROMAGNETIC DEVICE**

(71) Applicant: Premo, SL, 29590 Campanillas, Málaga (ES)
(72) Inventor: MARTÍNEZ CABRERA, David, 29640 Fuengirola (ES); RODRÍGUEZ GONZÁLEZ, Pablo, 18014 Granada (ES); NAVARRO PÉREZ, Francisco Ezequiel, 08006 Barcelona (ES); MUTHUSAMY, VIJAYAKUMAR, 637408 Rasipuram (Namakkal) (IN)
(74) Representative: Torner, Juncosa I Associats, SL

(57) **Abstract**

Cooled power electromagnetic device comprising an enclosure structure (10), including at least one refrigerated wall (11), housing power electromagnetic components (20), a circuit board (30) with power electronic semiconductors (31) and a heat transfer potting (40), wherein the power electromagnetic components (20) contain or are attached or are adjacent to the at least one refrigerated wall (11); wherein the power electromagnetic components (20) are attached or facing the circuit board (20), the circuit board (30) and the at least one refrigerated wall (11) are parallel to each other; or the circuit board (30) and the at least one refrigerated wall (11) define a dihedral, the power electromagnetic components (20) or parts thereof being interposed between the at least one refrigerated wall (11) and the circuit board (30); the power electromagnetic components (20) providing a thermal path therethrough for the transfer of heat towards the at least one refrigerated wall (11).

## Description

### Technical field

The present invention is directed to a cooled power electromagnetic device, for example an on-board or an or an off-board charger for an electric vehicle.

### Background of the Invention

Cooled power electromagnetic devices integrating power electromagnetic components, a circuit board with power electronic semiconductors and a heat transfer potting in an enclosure structure made of thermal conductive material with a cooling flow path integrated in at least one wall of said enclosure structure are well known for many applications, in particular for in board chargers for electric vehicles.

Different dispositions of the components constitutive of the device are known, resulting in different performances of the cooling effect, produced by the wall with a cooling flow path, on the power electromagnetic components and in particular on the circuit board with power electronic semiconductors, which can reach very high temperatures if not properly cooled.

The proposed invention provides a particular disposition of the components of the cooled power electromagnetic device producing a particularly effective cooling effect on the power electromagnetic components and in particular on the circuit board with power electronic semiconductors, in a cost effective and easy to assembly manner, among other advantages.

### Description of the Invention

The present invention concerns to a cooled power electromagnetic device, as defined in claim 1.

The proposed cooled power electromagnetic device comprises, in a manner already known in the state of the art:
an enclosure structure made of a thermal conductive material, including at least one refrigerated wall with a cooling flow path integrated therein, the enclosure structure housing power electromagnetic components, a circuit board and a heat transfer potting filling gaps between the power electromagnetic components, the circuit board and the enclosure structure, wherein
the power electromagnetic components are attached to the at least one refrigerated wall, or are facing and adjacent to the at least one refrigerated wall or have the at least one refrigerated wall inserted therein, and
the circuit board includes power electronic semiconductors configured to operate with a current of at least 5 amperes;

It will be understood that the expression "thermal conductive material" refers to a solid material with a thermal conductivity exceeding 100 W/mK at 25°C, such as metals (e.g., copper, aluminum, silver).

Also, the expression "heat transfer potting" refers to a hardenable composition, applied in a liquid or semi-liquid state and later hardened, to encapsulate electric and electronic components. Upon hardening, this heat transfer potting exhibits a thermal conductivity exceeding, for example, 1 W/m·K at 25°C to facilitate heat transfer away from the components.

The power electromagnetic components are components comprising at least one magnetic core and at least one winding of conductive wire associated therewith, configured to utilize electromagnetic fields to transfer electrical power between circuits and/or to convert electrical power from one form to another (e.g., AC to DC, voltage levels). The power electromagnetic components can be, for example, transformers (step-up, step-down, isolation) or inductors (for filtering, energy storage).

The "power electronic semiconductor" refers to a solid-state device fabricated from semiconductor materials like silicon or silicon carbide. These devices are specifically designed for power electronics applications, enabling them to handle large currents (e.g., exceeding 5 Ampere) and optionally also high voltages (e.g., exceeding 100V).

The enclosure structure defines a hollow interior where the electric and electronic components are contained, said hollow interior being at least partially delimited by external walls of the enclosure structure. The enclosed structure can be made of a single piece, in which case the at least one refrigerated wall will be one of the external walls of this single piece element, which delimits the housing of the enclosure structure, or can be made of several independent pieces connected together, in which case the at least one refrigerated wall can be one of those pieces or integrated in one of those pieces.

The proposed at least one refrigerated wall will include at least one channel, defining a cooling flow path. This at least one refrigerated wall can be made of a base plate with the at least one channel drilled therein, or engraved on one surface thereof and sealed through a cover plate overlapped thereto or can be made of two plates each including complementary channels engraved intended to define the cooling flow path when combined.

When a cooling fluid, such a cooling liquid, circulated through the cooling flow path the at least one refrigerated wall is cooled down.

According to the above the power electromagnetic components are embedded in the heat transfer potting and facing or attached to the at least one refrigerated wall, or with at least one refrigerated wall inserted therein, typically tightly inserted in a gap defined in a magnetic core of the power electromagnetic components. Therefore, the power electromagnetic components are effectively cooled by the at least one refrigerated wall.

The present invention also proposes the following features:
the power electromagnetic components are attached to the circuit board, or are facing the circuit board, and
the circuit board and the at least one refrigerated wall are parallel to each other, the power electromagnetic components or parts thereof being interposed between the at least one refrigerated wall and the circuit board; or
the circuit board and the at least one refrigerated wall define a dihedral, the power electromagnetic components or parts thereof being interposed between the at least one refrigerated wall and the circuit board in a direction perpendicular to a bisector plane defined by the dihedral;
the power electromagnetic components providing a thermal path therethrough for the transfer of heat, generated by the power electronic semiconductors, from the circuit board towards the at least one refrigerated wall.

According to the above the power electromagnetic components are cooled by the at least one refrigerated wall and are interposed between the at least one refrigerated wall and the circuit board, the power electromagnetic components acting as a heat sink for the circuit board, which cooperates with the at least one refrigerated wall to evacuate the heat generated by the power electronic semiconductors. This effect is particularly effective when the power electronic semiconductors, when in use, reach a temperature much higher than the temperature of the power electromagnetic components.

When the at least one refrigerated wall and the circuit board are parallel to each other, the power electromagnetic components, or parts thereof, typically a majority part thereof, will be placed between those two elements.

When the at least one refrigerated wall and the circuit board define a dihedral, the power electromagnetic components, or parts thereof, will be also placed between those two elements in a direction perpendicular to a bisector plane defined by the dihedral.

It will be understood that a dihedral is defined between two planar elements contained in two planes intersecting to each other in an intersection edge, both planes forming an angle under 180°, preferably under 120° or equal or lower than 90°.

According to a preferred embodiment, the dihedral is defined between the circuit board and the at least one refrigerated wall perpendiculars to each other.

The bisector plane is a plane dividing the dihedral in two identical halves, said bisector plane intersecting both intersecting planes at the same intersection edge. In the previous example, the bisector plane will divide a dihedral of 90° in two halves of 45°.

According to the above, the power electromagnetic component, or part thereof, is housed in the dihedral, between the at least one cooling wall and the circuit board. Preferably all the power electromagnetic components of the device are in this position, or all the power electromagnetic components have a part thereof or a majoritarian part thereof in said position interposed between the at least one refrigerated wall and the circuit board.

This construction provides a simple, compact, cheap, and reliable construction for the cooled power electromagnetic device with a highly efficient heat dissipation system allowing for high energy densities.

As will be understood by the skilled person, the circuit board may also include other passive components, such resonant capacitors, R-C dumping circuits, etc.

The power electromagnetic device may also include additional circuit boards, with or without electronic semiconductors, in other locations.

In a preferred embodiment, the at least one refrigerated wall may comprise one first refrigerated wall of the enclosure structure perpendicular to the circuit board.

Alternatively, the at least one refrigerated wall may comprise in addition to said one first refrigerated wall of the enclosure structure perpendicular to the circuit board, second refrigerated walls, interposed between adjacent power electromagnetic components and/or third refrigerated walls tightly inserted in the interior of each power electromagnetic components, typically in a slit provided in a magnetic core of the power electromagnetic component.

According to an optional embodiment, the enclosure structure can include additional walls, preferably perpendicular to the at least one refrigerated wall, in uninterrupted thermal contact with the at least one refrigerated wall providing a thermal path therethrough for the transfer of heat towards the at least one refrigerated wall. Those additional walls can be internal walls of the enclosure, housed therein and embedded in the heat transfer potting, or can be external walls of the enclosure, defining external sides thereof with one side facing inwards the enclosure, in contact with the heat transfer potting, and the other side facing outwards in contact with the surrounding air.

It will be understood that the uninterrupted thermal contact is a direct contact or an indirect contact though an interposed thermally conductive material, for example less than 5mm or preferably less than 2mm of heat transfer potting or other materials with thermal conductivity equal or higher than the thermal conductivity of the heat transfer potting.

### Brief description of the Figures

The foregoing and other advantages and features will be more fully understood from the following detailed description of an embodiment with reference to the accompanying drawings, to be taken in an illustrative and non-limitative manner, in which:

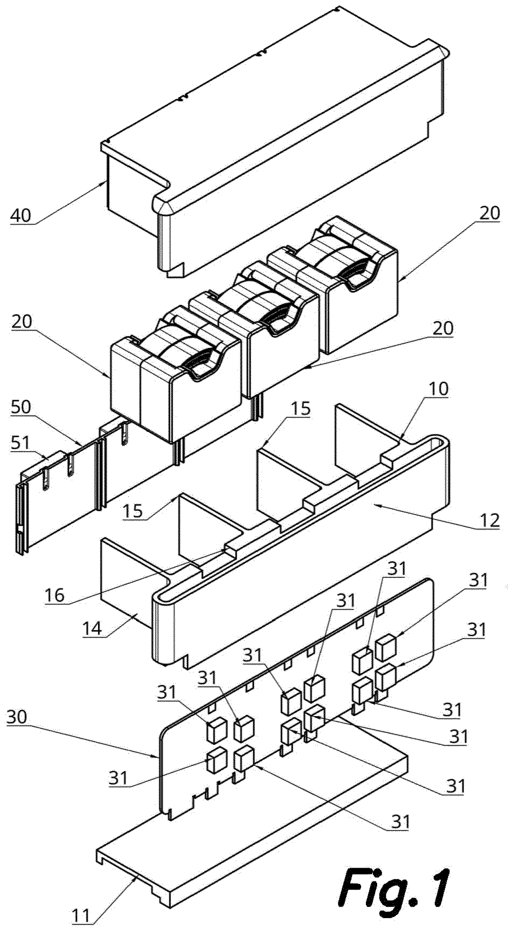

Fig. 1 is an exploded perspective view of the cooled power electromagnetic device according to a first embodiment in which the at least one refrigerated wall is an independent element attached to a lower open end of the rest of the enclosure structure as a lower lid;
Fig. 2 is a transversal cross-sectional view of the device shown in Fig. 1 once assembled, where the electric connections between the elements are depicted with dashed lines;
Fig. 3 is a transversal cross-sectional view of the device according to an alternative embodiment devoid of second internal wall;

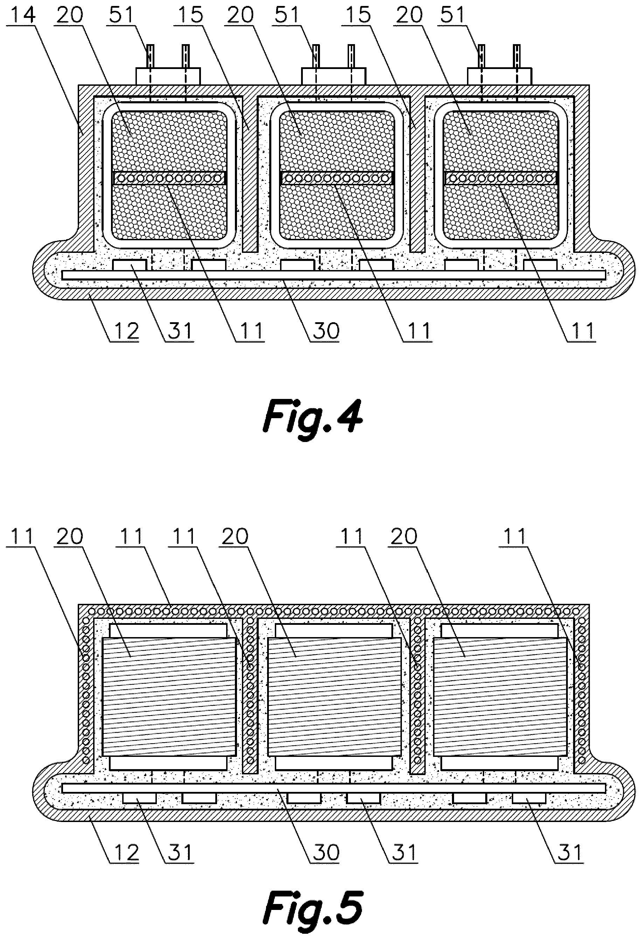

Fig. 4 is a transversal cross-sectional view of the device according to an alternative embodiment where the at least one refrigerated wall are, or includes three walls each tightly inserted in the magnetic core of each power electromagnetic component;
Fig. 5 is a transversal cross-sectional view of the device according to an alternative embodiment where the at least one refrigerated wall includes one first external wall of the enclosure structure facing all the power electromagnetic components, two external walls perpendiculars to the first external wall, each facing one electromagnetic component, and two internal walls perpendicular to the first external wall and interposed between two adjacent power electromagnetic components, all the refrigerated walls having perforated channels and being connected to each other.

### Detailed Description of the Invention and of particular embodiments

The proposed cooled power electromagnetic device comprises, as described in the appending claims, the following features:
An enclosure structure 10 made of a thermal conductive material, including one at least one refrigerated wall 11 with a cooling flow path integrated therein, the enclosure structure 10 housing power electromagnetic components 20, a circuit board 30 and a heat transfer potting 40 filling gaps between the power electromagnetic components 20, the circuit board 30 and the enclosure structure 10.

According to a preferred embodiment, the at least one refrigerated wall 11 constitutes one of the external sides of the enclosure structure 10, with at least one channel constitutive of a cooling flow path integrated therein.

According to a preferred embodiment, the enclosure structure 10 comprises at least two independent components attached to each other, one component being the at least one refrigerated wall 11, which includes the cooling flow path therein allowing the pass of a cooling fluid therethrough producing a cooling of the at least one refrigerated wall 1, and the other component being the rest of the enclosure structure 10 defined by a plurality of interlinked walls perpendiculars to the at least one refrigerated wall.

Alternatively, the enclosed structure 10 can be a single-piece component having the cooling flow path integrated in one of its external walls, which will be the at least one refrigerated wall.

According to another embodiment, the at least one refrigerated wall 11 can be a wall contained within the enclosure structure 10, embedded in the heat transfer potting 40, for example an inner wall of the enclosure structure 10 placed between two adjacent power electromagnetic components 20.

According to yet another embodiment, the at least one refrigerated wall 11 can be a wall tightly inserted in a slit provided in a magnetic core of the power electromagnetic components 20.

Also, any combination of the above three possible embodiments is also within the scope of the present document.

In any case, the power electromagnetic components 20 will be attached to the at least one refrigerated wall 11 or will be facing the at least one refrigerated wall 11. Any gap existing between the power electromagnetic components 20 and the at least one refrigerated wall will be filled with the heat transfer potting 40, preferably with a thickness of heat transfer potting 40 of less than 10mm or less than 5mm.

The circuit board 30 includes power electronic semiconductors 31 configured to operate with a current of at least 5 amperes, and therefore producing a lot of heat to be evacuated to prevent overheating, loss of performance or even damage to the device.

According to the proposed invention, the circuit board 30 and the at least one refrigerated wall 11 can be parallel to each other, the power electromagnetic components 20 or parts thereof being interposed between the at least one refrigerated wall 11 and the circuit board 30.

According to an alternative embodiment of the proposed invention, the circuit board 30 and the at least one refrigerated wall 11 define a dihedral, the power electromagnetic components 20 or parts thereof being interposed between the at least one refrigerated wall 11 and the circuit board 30 in a direction perpendicular to a bisector plane defined by the dihedral.

In any case, the power electromagnetic components 20 will provide a thermal path therethrough for the transfer of heat, generated by the power electronic semiconductors 31, from the circuit board 30 towards the at least one refrigerated wall 11.

In a preferred embodiment, the circuit board 30 is perpendicular to the at least one refrigerated wall 11, forming a dihedral at 30°. In this case, the power electromagnetic components, or parts thereof, preferably the majority thereof, are housed in the dihedral, interposed between the circuit board 30 and the at least one refrigerated wall 11, in a direction perpendicular to a bisector plane.

In an example where the circuit board 30 and the at least one refrigerated wall 11 are perpendicular to each other, the bisector plane is a plane forming a 45° angle with both the circuit board and the at least one refrigerated wall 11.

A projection of the circuit board, in a direction perpendicular to the bisector plane, will reach the at least one refrigerated wall passing at least through parts of the power electromagnetic components.

The proposed position of the power electromagnetic components 20 regards to the at least one refrigerated wall 11 ensures an optimal cooling thereof.

This construction allows the power electromagnetic components 20 to provide a thermal path therethrough for the transfer of heat, generated by the power electronic semiconductors 31, from the circuit board 30 towards the at least one refrigerated wall 11, because the power electromagnetic components 20 will be cooler than the power electronic semiconductors 31.

Preferably, the enclosed structure 10 further comprises a second external wall 12 facing the circuit board, parallel and adjacent thereto.

Optionally, the enclosure structure 10 can include additional walls 14, 15 and/or 16, typically perpendicular to the at least one refrigerated wall 11, in uninterrupted thermal contact with the at least one refrigerated wall 11 providing a thermal path therethrough for the transfer of heat towards the at least one refrigerated wall 11. In this manner, also other walls of the enclosure structure different from the at least one refrigerated wall also actuate as part of a cooling structure to evacuate heat from the device.

It will be understood that the uninterrupted thermal contact is a direct contact or an indirect contact though an interposed thermally conductive material, for example less than 5mm or preferably less than 2mm of heat transfer potting or other materials with thermal conductivity equal or higher than the thermal conductivity of the heat transfer potting.

According to one embodiment of the present invention, at least some of the additional walls 14, 15 and/or 16 of the enclosure structure 10 will be first internal walls 15, housed within the enclosure structure, and perpendicular to the at least one refrigerated wall 11.

Each first internal wall 15 will be interposed between two adjacent power electromagnetic components 20. Those first internal walls 15 will be part of the cooling structure and therefore will be in uninterrupted thermal contact with the at least one refrigerated wall 11 of the enclosure structure 10. Its position, between the power electromagnetic components 20, ensures an additional cooling thereof, improving its function as a thermal path for the transfer of heat generated by the power electronic semiconductors 31.

According to the above, the enclosure structure 10, excluding the at least one refrigerated wall 11, may have a comb-shaped configuration formed by parallel first internal walls and by two third external walls parallel to the first internal walls, with all the power electromagnetic components 10 being housed between two of those parallel walls adjacent to each other.

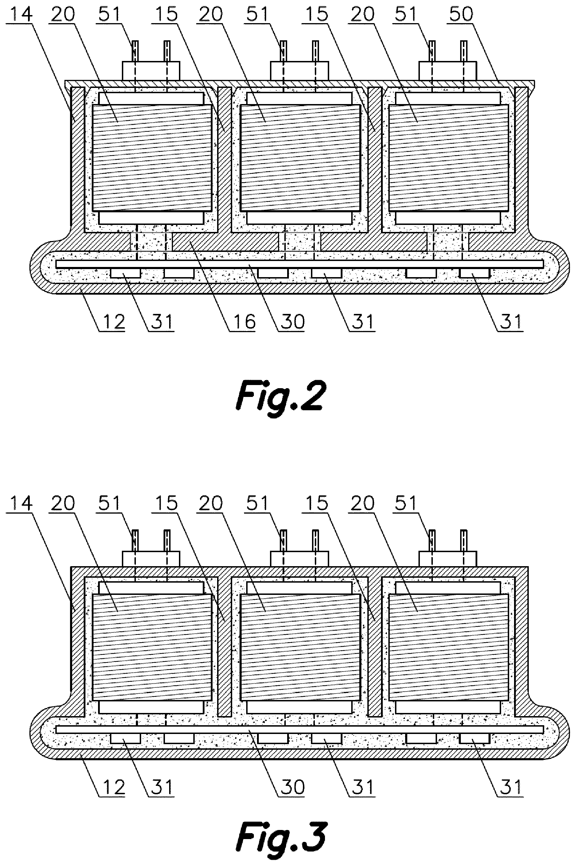

All those at least one refrigerated walls 11 and third external walls 14 will be connected at least through one of its ends to the second internal wall 16, interposed between the power electromagnetic components 20 and the circuit board 30, as shown in Fig. 2.

Alternatively or additionally, all those at least one refrigerated walls 11 and third external walls 14 will be connected through one of its ends to one fourth external wall parallel to the second external wall and opposed thereto, said fourth external wall being facing and adjacent to all the power electromagnetic components 20, as shown in Fig. 3.

Additionally or alternatively, at least some of the additional walls 14, 15 and/or 16 of the enclosure structure 10 can be at least one second internal wall 16 of the enclosure structure 10, perpendicular to the at least one refrigerated wall 11, interposed between the circuit board 30 and the power electromagnetic components 20. Said at last one second internal wall 16 will include apertures between the circuit board 30 and each of the power electromagnetic components 20, allowing heat transfer from the circuit board 30 towards the cooled power electromagnetic components 20.

Preferably, each first internal wall 15 has one end connected to one main surface of the at least one second internal wall 16, providing heat transfer between the second and first internal walls 16, 15.

The circuit board 30 and the power electromagnetic components 20 are preferably electrically connected through said apertures of the second internal wall 16. This facilitates the interconnection between the components reducing the length of such connections and reducing the generation of electromagnetic interferences and also facilitates the insertion of those components in the enclosure structure 10 even after being connected if necessary.

The cooled power electromagnetic device may further comprise an electrically isolated external wall 50, perpendicular to the at least one refrigerated wall 11 and opposed to the second external wall 12. The electrically isolated external wall 50 will be attached to the enclosure structure 10, facing all the power electromagnetic components 20, the electrically isolated external wall 50 being adjacent to said power electromagnetic components 20.

This electrically isolated external wall 50 will provide a closure for one open side of the enclosure structure 10.

The electrically isolated external wall 50 may further include electrical connectors 51 accessible from the exterior of the cooled power electromagnetic device, each electrical connector 51 being connected to one power electromagnetic component 20.

The electrically isolated external wall 50 may also include coupling configurations intended to receive complementary edges of the enclosure structure 10 providing attachment. For example, the coupling configurations can be elongated channels, typically perpendicular to the at least one refrigerated wall, where the edges defined at free ends of several walls of the enclosure structure 10 can be inserted providing the attachment.

According to one embodiment of the invention, all the power electronic semiconductors 31 are on one side of the circuit board 30 facing the second external wall 12.

Alternatively, all the power electronic semiconductors 31 are on one side of the circuit board 30 facing the power electromagnetic components 20.

Optionally, the power electronic semiconductors 31 are on both sides of the circuit board 30, some facing the second external wall 12 and some facing the power electromagnetic components 20.

According to one embodiment, the enclosed structure 10 comprises an extrudable section with a constant cross section obtainable by extrusion, defined between two opposed first and second open ends and made of interconnected walls defining a continuous profile extending in a direction parallel to the circuit board 30.

This extrudable section may comprise, for example, the first and/or second internal walls 15, 16 and at least the second external wall 12 of the enclosure structure 10 perpendicular to the at least one refrigerated wall, all interconnected defining a continuous profile with a constant cross-section obtainable by extrusion.

Said continuous profile will have a constant cross-section along the entire height of such walls resulting in a continuous profile obtainable by extrusion. Optionally, the constant cross-section will include some openings or engravements producible though a drilling or milling.

Said continuous profile will constitute a main section of the enclosure structure 10 and will have first and second open ends opposed to each other.

The at least one refrigerated wall 11 can be, for example, a first lid closing at least most of the first open end of the main section of the enclosure structure 10.

At least most of the second open end of the main section of the enclosure structure 10 can be closed by a second lid or can be closed by the thermal potting 40 filling the enclosure structure 10 and covering the power electromagnetic components 20 and the circuit board 30.

Optionally, the enclosure structure may include a slit and a minor portion of the circuit board 30, devoid of power electronic semiconductors and including electric connectors, may protrude from the enclosure structure 10 through said slit.

## Claims

1. Cooled power electromagnetic device comprising:
an enclosure structure (10) made of a thermal conductive material, including at least one refrigerated wall (11) with a cooling flow path integrated therein, the enclosure structure (10) housing power electromagnetic components (20), a circuit board (30) and a heat transfer potting (40) filling gaps between the power electromagnetic components (20), the circuit board (30) and the enclosure structure (10), wherein
the power electromagnetic components (20) are attached to the at least one refrigerated wall (11), or are facing and adjacent to the at least one refrigerated wall (11) or have the at least one refrigerated wall (11) inserted therein, and
the circuit board (30) includes power electronic semiconductors (31) configured to operate with a current of at least 5 amperes;
**characterized in that** the power electromagnetic components (20) are attached to the circuit board (20), or are facing the circuit board (20), and
the circuit board (30) and the at least one refrigerated wall (11) are parallel to each other, the power electromagnetic components (20) or parts thereof being interposed between the at least one refrigerated wall (11) and the circuit board (30); or
the circuit board (30) and the at least one refrigerated wall (11) define a dihedral, the power electromagnetic components (20) or parts thereof being interposed between the at least one refrigerated wall (11) and the circuit board (30) in a direction perpendicular to a bisector plane defined by the dihedral;
the power electromagnetic components (20) providing a thermal path therethrough for the transfer of heat, generated by the power electronic semiconductors (31), from the circuit board (30) towards the at least one refrigerated wall (11).

2. The cooled power electromagnetic device according to claim 1 wherein the at least one refrigerated wall (11) comprises:
one first refrigerated wall of the enclosure structure perpendicular to the circuit board (20), or
one first refrigerated wall of the enclosure structure perpendicular to the circuit board (20) and second refrigerated walls, interposed between adjacent power electromagnetic components and/or third refrigerated walls tightly inserted in the interior of each power electromagnetic components (20).

3. The cooled power electromagnetic device according to claim 1 or 2 wherein the enclosure structure includes additional walls (14, 15, 16, 17) in uninterrupted thermal contact with the at least one refrigerated wall (11) providing a thermal path therethrough for the transfer of heat towards the at least one refrigerated wall (11).

4. The cooled power electromagnetic device according to claim 3 wherein at least some of the additional walls (14, 15, 16, 17) of the enclosure structure (10) are:
first internal walls (15), interposed between adjacent power electromagnetic components (20); and/or
second internal wall (16) interposed between the circuit board (30) and the power electromagnetic components (20), the at last one second internal wall (16) including apertures between the circuit board (30) and each of the power electromagnetic components (20); and/or
third internal walls (17) tightly inserted in the interior of the power electromagnetic components (20).

5. The cooled power electromagnetic device according to claim 4 wherein each first internal wall (15) has one end connected to one main surface of the at least one second internal wall (16).

6. The cooled power electromagnetic device according to claim 4 or 5 wherein the circuit board (30) and the power electromagnetic components (20) are electrically connected through said apertures.

7. The cooled power electromagnetic device according to any preceding claim wherein the cooled power electromagnetic device further comprises an electrically isolated external wall (50), delimiting the housing of the enclosed structure (10), the electrically isolated external wall (50) being attached to the enclosure structure (10), facing all the power electromagnetic components (20) and adjacent thereto.

8. The cooled power electromagnetic device according to claim 7 wherein the electrically isolated external wall (50) further includes:
electrical connectors (51) accessible from the exterior of the cooled power electromagnetic device, each electrical connector (51) being connected to one power electromagnetic component (20); and/or
coupling configurations configured to receive complementary edges of the enclosure structure (10) providing attachment.

9. The cooled power electromagnetic device according to any preceding claim wherein the power electronic semiconductors (31) are:
all on one side of the circuit board (30) facing the power electromagnetic components (20); or
all on one side of the circuit board (30) opposed to the side facing the power electromagnetic components (20); or
on both sides of the circuit board (30), some on the side facing the power electromagnetic components (20) and some on the opposed side not facing the power electromagnetic components (20).

10. The cooled power electromagnetic device according to any preceding claim wherein the enclosed structure (10) comprises an extrudable section with a constant cross section obtainable by extrusion, defined between two opposed first and second open ends and made of interconnected walls defining a continuous profile extending in a direction parallel to the circuit board (30).

11. The cooled power electromagnetic device according to claim 10 wherein the at least one refrigerated wall (11) is a first lid closing at least most of the first open end of the extrudable section of the enclosure structure (10).

12. The cooled power electromagnetic device according to claim 10 or 11 wherein
at least most of the second open end of the main section of the enclosure structure (10) is closed by a second lid; or
at least most of the second open end of the main section of the enclosure structure (10) is closed by the thermal potting (40) filling the enclosure structure (10) and covering the power electromagnetic components (20) and the circuit board (30).

13. The cooled power electromagnetic device according to any preceding claim wherein the enclosure structure (10) includes a slit and wherein a minor portion of the circuit board (30), devoid of power electronic semiconductors (32) and including electric connectors, protrudes from the enclosure structure (10) through the slit.
